# EUROPEAN PATENT APPLICATION

(11) **EP 3 826 182 A1**
(43) Date of publication of application: **26.05.2021**
(21) Application number: 19210500.5
(22) Date of filing: 21.11.2019
(51) Int. Cl.: H03K 17/693, H03K 17/74

(54) **ELECTRONIC RF SWITCH ARRANGEMENT AND METHOD OF HARMONIC CONTROL OF ELECTRONIC RF SWITCH ARRANGEMENT**

(71) Applicant: Bittium Wireless Oy, 90590 Oulu (FI)
(72) Inventor: Lapinoja, Mikko, 90590 Oulu (FI); Malkamäki, Pasi, 90590 Oulu (FI); Vimpari, Antti, 90590 Oulu (FI)
(74) Representative: Kolster Oy Ab

(57) **Abstract**

An electronic radio frequency switch arrangement comprises switch branches (100), each of which comprises at least one diode switch (102), and the switch branches (100) have an electrical anti-parallel coupling of the diode switches (102) therebetween, a number of the switch branches (100) being 2^{∗}n + 1, where n is a positive integer. One of the diode switches (102), which comprises at least one electrical anti-series coupling (104) of diodes, is configured to be biased into an electrically conductive state for harmonic cancellation on the basis of the electrical anti-series coupling (104), and the diode switches (102) other than said one of the diode switches (102) are configured to be biased in an electrically non-conductive state for harmonic reduction on the basis of the anti-parallel coupling.

## Description

### Field

The invention relates to an electronic radio frequency switch arrangement.

### Background

A problem with radio frequency switched filter banks is the harmonic level produced by the antenna-side switch, because the harmonics cannot be filtered out and because the harmonics can rise above a spectrum mask with high output power.

The problem with the harmonics has been reduced in the prior art by using high power switches such as diode switches. However, increasing the size of diode switches causes other problems: In addition to physical size limitations, bigger switches/diodes typically do not allow as high frequencies as the smaller ones, the smaller ones having smaller capacitance, for example. Hence, there is a need for a better harmonics control.

### Brief description

The invention is defined by the independent claims. Embodiments are defined in the dependent claims.

### List of drawings

Example embodiments of the present invention are described below, by way of example only, with reference to the accompanying drawings, in which
Figures 1A to 1D illustrates examples of anti-series and anti-parallel couplings of diodes;
Figure 2 illustrates an example of an electronic radio frequency switch arrangement;
Figure 3 illustrates an example of the electronic radio frequency switch arrangement which has a receiver branch and a low power radio frequency branch in addition to power transmission branches;
Figure 4 illustrates an example of the electronic radio frequency switch arrangement which has two sections of diode switch branches;
Figure 5 illustrates an example of a branch which has an anti-series coupling of diodes;
Figure 6 illustrates an example of how DC electric currents flow in the electronic radio frequency switch arrangement when one of the diode switches having an anti-series coupling of diodes is biased into an electrically conducting state;
Figure 7 illustrates another example of how DC electric currents flow in the electronic radio frequency switch arrangement when one of the diode switches having an anti-series coupling of diodes is biased into an electrically conducting state;
Figure 8 illustrates still another example of how DC electric currents flow in the electronic radio frequency switch arrangement when one of the diode switches having an anti-series coupling of diodes is biased into an electrically conducting state;
Figure 9 illustrates another example of how DC electric currents flow in the electronic radio frequency switch arrangement when a diode switch of a receiver branch is biased into an electrically conducting state;
Figure 10 illustrates an example of connection diodes that are coupled opposite to the previous examples; and
Figure 11 illustrates of an example of a flow chart of a method of harmonic control of an electronic radio frequency switch arrangement.

### Description of embodiments

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned. All combinations of the embodiments are considered possible if their combination does not lead to structural, operational or logical contradiction.

It should be noted that while Figures illustrate various embodiments, they are simplified diagrams that only show some structures and/or functional entities. The connections shown in the Figures may refer to logical or physical connections. It is apparent to a person skilled in the art that the described apparatus may also comprise other functions and structures than those described in Figures and text. It should be appreciated that details of some functions, structures, and the signalling used for measurement and/or controlling are irrelevant to the actual invention. Therefore, they need not be discussed in more detail here.

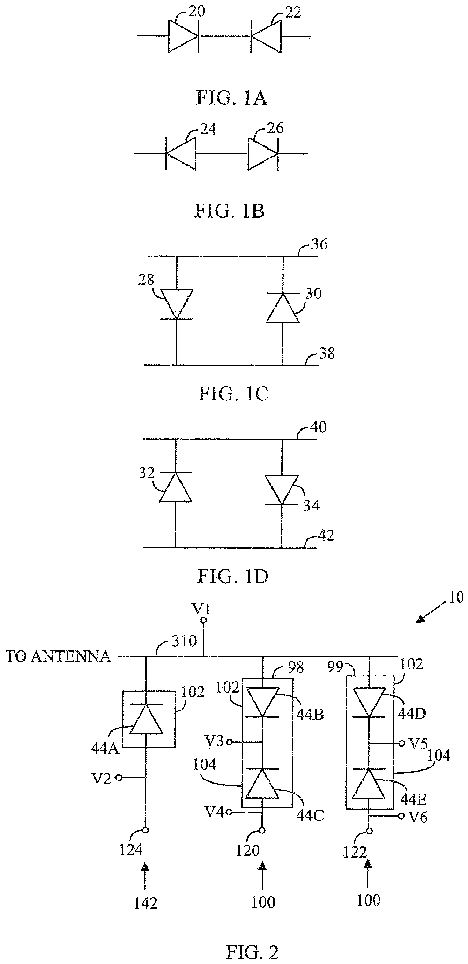

Figures 1A to 1D show examples of what anti-series and anti-parallel couplings of diodes mean, although a person skilled in the art is familiar with these electrical couplings, *per se.* Figure 1A illustrates an example of two diodes 20 and 22, which are electrically coupled in series. This series coupling is called anti-series coupling because cathodes of the diodes 20 and 22 are coupled together.

Figure 1B illustrates an example of two diodes 24 and 26, which are also electrically coupled in series. This series coupling is, like that of Figure 1A, called anti-series coupling because anodes of the diodes 24 and 26 are coupled together. A diode coupling is called anti-series when the same terminals of serially coupled diodes are electrically coupled with each other.

Figure 1C illustrates an example of two diodes 28 and 30, which are electrically coupled in parallel. This parallel coupling is called anti-parallel coupling because the diodes 28 and 30 are in opposite positions between the upper and lower conductors 36 and 38. That is, the anode of the diode 28 and the cathode of the diode 30 are coupled with the upper conductor 36 while the cathode of the diode 28 and the anode of the diode 30 are couple with the lower conductor 38.

Figure 1D illustrates an example of two diodes 32 and 34, which are electrically coupled in parallel. This parallel coupling is called anti-parallel coupling because the diodes 32 and 34 are in opposite positions between the upper and lower conductors 40 and 42. That is, the cathode of the diode 32 and the anode of the diode 34 are coupled with the upper conductor 40 while the anode of the diode 32 and the cathode of the diode 34 are coupled with the lower conductor 42. In an anti-parallel coupling different terminals of a pair of parallel coupled diodes are coupled with each other.

Figure 2 illustrates a simple example of an electronic RF (Radio Frequency) switch arrangement 10. The electronic radio frequency switch arrangement 10 comprises switch branches 100, 142, each of which comprises at least one diode switch 102. The switch branches 100 and the switch branch 142 have an electrical anti-parallel coupling therebetween. A number of the switch branches 100 is 2^{∗}n + 1, where n is a positive integer. The positive integers are numbers 1, 2, 3, ... not including zero. Mathematically the positive integers belong to the set denoted Z+. In Figure 2, the diode switches 102, which comprise at least one electrical anti-series coupling 104 of diodes 44B-44C or 44D-44E, are in the power transmission switch branches and may receive a radio frequency power signal at input terminals 120, 122 and pass the radio frequency power signal to an antenna. The switch branch 142, which has a diode 44A, may receive a radio frequency signal from the antenna and pass it toward a receiver circuit through a terminal 124.

When an anti-series coupling 104 of diodes is biased into an electrically conducting state, it allows a radio frequency power signal to pass therethrough from an input terminal 120, 122 of radio frequency power transmitter to the antenna.

One 98, 99 of the diode switches 102, which comprises at least one electrical anti-series coupling 104 of diodes 44B-44C or 44D-44E, is biased into an electrically conductive state for harmonic cancellation on the basis of the electrical anti-series coupling 104. The bias may be permanent or temporal. When the bias is temporal, one 98, 99 of the diode switches 102 is biased into an electrically conductive state at a time. That is, the diode switches 102 may be set in an electrically conducting state one by one. The diode switches 102 other than said one 98, 99 of the diode switches 102 and the diode switch 142 are biased in an electrically non-conductive state for harmonic cancellation on the basis of the anti-parallel coupling.

In Figure 2, said one (for example 98) of the diode switches 102 comprises the electrical anti-series coupling 104 of diodes 44B-44C and it may be biased in an electrically conductive state. Then the diodes 44A and 44D form the anti-parallel coupling of diodes. If another (for example 99) of the diode switches 102, which comprises the electrical anti-series coupling 104 of diodes 44D-44E, is biased into an electrically conductive state, then the diodes 44A and 44B form the anti-parallel coupling of diodes. Correspondingly, diodes 44D and 44E form the anti-series coupling of diodes.

The diode 44A may be biased into an electrically non-conducting state by providing a higher electrical potential to an input V1 than to an input V2. The input V1 is common to all diode switches 102 the electronic radio frequency switch arrangement 10. Electrically, a potential difference between any two points refers to a voltage between the points. The diode 44B may be biased in an electrically conducting state by providing a higher electrical potential to the input V1 than to an input V3. The diode 44C may be biased in an electrically conducting state by providing a higher electrical potential to the input V4 than to an input V3. The diode 44D may be biased in an electrically non-conducting state by providing a lower electrical potential to the input V1 than to an input V5. The diode 44E may be biased in an electrically non-conducting state by providing a lower electrical potential to the input V6 than to an input V5.

The diode 44B may be biased in an electrically non-conducting state by providing a lower electrical potential to the input V1 than to an input V3. The diode 44C may be biased in an electrically non-conducting state by providing a lower electrical potential to the input V4 than to an input V3. The diode 44D may be biased in an electrically conducting state by providing a higher electrical potential to the input V1 than to an input V5. The diode 44E may be biased in an electrically conducting state by providing a higher electrical potential to the input V6 than to an input V5. In these examples, electric current flows from a higher potential to a lower potential. The inputs V1 to V6 may be electrically contacted with DC (Direct Current) voltage sources, for example. The DC voltage sources providing the potentials to the inputs V1 to V6 may be adjustable, and by adjusting their voltages to values characteristics to the electrical circuit configuration of the electronic radio frequency switch arrangement 10 the harmonics distortion can be reduced or eliminated. An electric current through the diodes 44A, 44B, 44C, 44D and 44E may be restricted by coupling a resistor (not shown in Figures) in series with them, for example.

In an embodiment, a first (98 in Figure 2) of the diode switches 102, which comprises the at least one electrical anti-series coupling 104 of diodes, may be biased into the electrically conductive state at a first moment, and a second (99 in Figure 2) of the diode switches 102, which comprises the at least one electrical anti-series coupling 104 of diodes, may be biased into the electrically conductive state at a second moment. In this example, the first and the second moments are different and the first of the diode switches 102 and the second of the diode switches 102 are different.

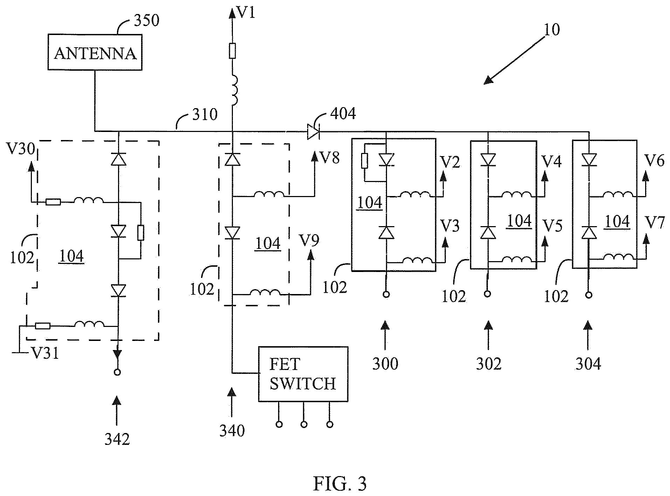

In an embodiment an example of which is illustrated in Figure 3, the switch branches 300, 302, 304, 340, 342 are electrically coupled in parallel between direct current inputs V1, V2, V3, V4, V5, V6, V7, V8, V9, V30, V31, where the input V1 is common to all diode switches 102. At least one of the switch branches 300, 302, 304, 340 is a radio frequency power transmission switch branch 300, 302, 304. The switch branch 340 is a radio frequency transmission switch branch and the switch branch 342 is a radio frequency receiver switch branch. However, the switch branches 340 and 342 are not necessarily needed in the electronic radio frequency switch arrangement.

Each of the switch branches 300, 302, 304, 340, 342 may comprise the diode switch 102, which receives bias on the basis of the DC potential/voltage. One terminal of each of the diode switches 102 has an electrical coupling with a conductor 310, which has an electrical connection with an antenna 350 for electromagnetic radio frequency power transmission, electromagnetic radio frequency transmission and/or electromagnetic radio frequency reception.

The diode switch 102 of each of the at least one radio frequency power transmission switch branch 300 to 304 comprises one of the at least one anti-series coupling 104 of diodes. The diodes of only one of the radio frequency power transmission switch branches 300 to 304 may be biased into an electrically conducting state, i.e. forward biased, to allow a radio frequency power signal to pass therethrough to the conductor 310 and toward the antenna 350. The only one of the radio frequency power transmission switch branches 300 to 304 may be the switch branch 300 at a certain moment, for example. At some other moment, the only one of the radio frequency power transmission switch branches 300 to 304 may be the switch branch 300, 302 or 304.

A diode of the diode switch 102 of each of the switch branches 300 to 304, 340, 342 other than said one of the at least one of the radio frequency power transmission switch branch 300 to 304 may then be biased into an electrically non-conducting state, i.e. reverse biased, to prevent the radio frequency signal, the radio frequency power signal and/or received radio frequency signal to pass therethrough.

In an embodiment an example of which is illustrated in Figures 2, 3 and 4, a difference between a number of anodes of the diode switches 102, which are coupled with the conductor 310, and cathodes of the diode switches 102, which are coupled with the conductor 310, may be at most one.

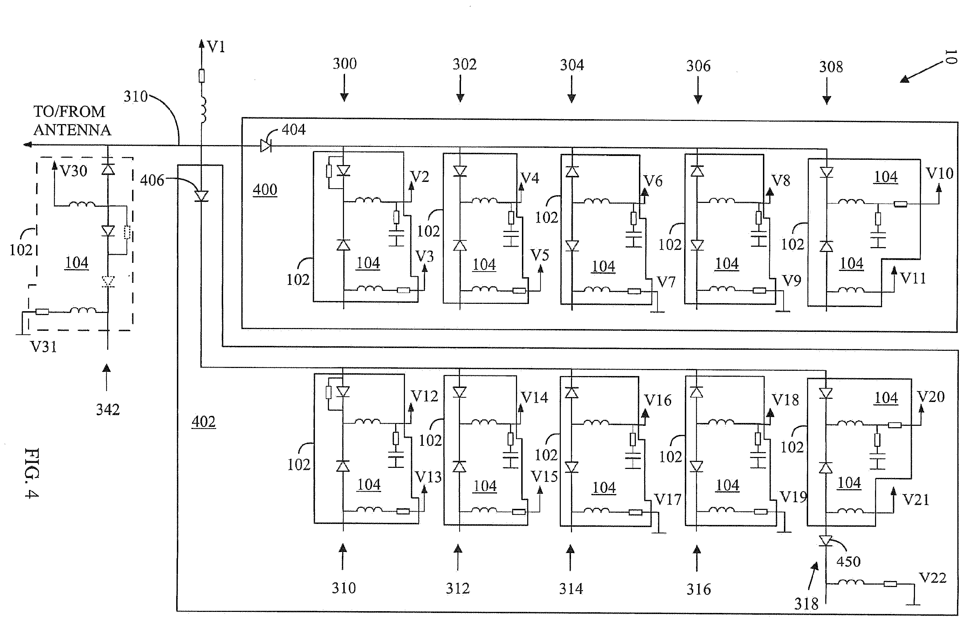

An example Figure 4 illustrates the electronic radio frequency switch arrangement that comprises two section 400, 402 of the radio frequency power transmission switch branches 300, 302, 304, 306, 308, 310, 312, 314, 316 and 318, which are electrically in parallel with each other and between the direct current inputs V1, V2, V3, V4, V5, V6, V7, V8, V9, V10, V11, V12, V13, V14, V15, V16, V17, V18, V19, V20, V21 and V22, where the input V1 is common to all the diode switches 102. In a second section 402, the last diode switch 102 having the DC inputs V20 and V21 may be coupled to a input V22 through an additional diode 450. The additional diode 450 may have its cathode coupled with or facing toward the input V22, which may be ground. The inputs V7, V9, V17, V19 and V22 may be coupled with the ground.

In an embodiment, the input V1 may be a few volts, such as about 2 V to 15 V, for example. In an embodiment, the input V1 may be between about 3 V to 10 V, for example. The input V1 may be adjustable, and it is set to a voltage or within a voltage range that reduces the harmonic disturbances efficiently. A voltage value of the input V1 depends on the components and the circuit structure used in the electronic radio frequency switch arrangement. A person skilled in the art can easily find a suitable value for the input V1 on the basis of test, simulation or theory.

The inputs V2, V4, V10, V12, V14 and V20 may be switchable between about Vₐₗ and Vₐₕ, for example, where Vₐₗ may be between about -5 V and 5 V and Vₐₕ may be between about 80 V to 160 V, for example. The inputs V6, V8, V16, V18, V21 may be switchable between about V_{bl} and V_{bh}, where V_{bl} may be about 2.5 V to 10 V and may V_{bh} be about -80 V to -160 V, for example. The inputs V3, V5, V13 and V15 may be between about 2.5 V to 10 V, for example. The input V11 may be between about - 80 V to - 160 V, for example.

The inputs V2, V4, V10, V12, V14 and V20 may be switchable between about 0 V and 120 V, for example. The inputs V6, V8, V16, V18, V21 may be switchable between about 5 V and -120 V. The inputs V3, V5, V13 and V15 may be about 5 V, for example. The input V11 may be about -120 V, for example. A scale of the values of inputs V2 to V22 may have a variation of about 50 V, for example. Hence, the inputs V6, V8, V16, V18, V21 may be switchable between about 5 V and -70 V, or about 5 V to -170 V, for example.

In general, the electronic radio frequency switch arrangement comprises at least one section 400, 402.

Each of the at least one section 400, 402 may comprise a connection diode 404, 406. The electrical coupling of the diode switches 102 with the conductor 310 is arranged in this configuration through the connection diode 404, 406. A cathode of the connection diode 404, 406 is coupled with the one terminal of each of the diode switches 102 of the at least one section 400, 402. An anode of the connection diode 404, 406 is coupled with the conductor 310 and directed toward the antenna 350.

In an embodiment, an anode of the connection diode 404, 406 may be coupled with the one terminal of each of the diode switches 102 of the anti-series coupling 104 of the diodes. This can be done by setting suitable electric potentials or voltages at inputs V1 to V22. A person skilled in the art is capable of doing this kind of coupling on the basis of what is taught in this document about coupling the cathode of the connection diode 404, 406 with the one terminal of each of the diode switches 102 of the at least one section 400, 402.

The diode switches 102 of the power transmission switch branches 300 to 318 of the at least one section 400, 402 have the anti-series coupling 104 of the diodes. Other terminal of each of the diode switches 102 of the anti-series coupling 104 are configured to receive the radio frequency signal from radio frequency power signal input terminal (120, 122 in Figure 2).

In an embodiment, the electronic radio frequency switch arrangement may comprise a plurality of the diode switches 102 that comprise at least one anti-series coupling 104 of diodes. In an embodiment, all the diode switches 102 of the electronic radio frequency switch arrangement may comprise at least one anti-series coupling 104 of diodes.

In an embodiment, the switch branches 300 to 318, 340, 342 may comprise at least one receiver switch branch 342. The at least one receiver switch branch 342 does not comprise a diode similar to the connection diode 404, 406 between the diode switch 102, which may have the anti-series coupling 104 of diodes, and the conductor 310. That is, the receiver switch branch 342 operates without such a diode an anode of which is coupled with the one terminal of the diode switch 102, and a cathode of which is directed toward the antenna 350.

In an embodiment, the switch branches 300 to 318, 340, 342 may comprise at least one limited power transmission switch branch 340 which is for limited power transmission. Power of the limited power radio transmission is less than the power of signals of the radio frequency power transmission. The at least one limited power transmission switch branch 340 of radio frequency does not comprise a diode similar to the connection diode 404, 406 between the diode switch 102 and the conductor 310. Correspondingly with the embodiment of the receiver branch switch 342, the limited power transmission switch 340 operates without such a diode (like diode 404) a cathode of which is coupled with the one terminal of the diode switch 102, and an anode of which is coupled with the conductor 310 and directed toward the antenna 350.

Alternatively, the switch branches 340 and 342 may be for high radio frequency power instead of limited radio frequency power, and correspondingly the switch branches 300 to 338 may be for limited radio frequency power. The lack of a connection diode 404, 406 is not a sign or necessity for a limited radio frequency power. Namely, the limited radio frequency power is typically so small that it does not cause too much harmonic disturbance. If the switch branch 340 were a high radio frequency power branch, the input V1 may be expanded to negative voltage/potential range in order to adjust an electric current of a first diode coupled with the conductor 310 with respect to another diode below it, which would then reduce the harmonic disturbance.

The same is true for the switch branch 342, where the electric current of a first diode coupled with the conductor 310 is adjusted with respect to those below it. The switch branches of limited power may also be a part of an anti-cancellation of harmonic disturbance when a high power radio frequency transmission is on, as it is in an embodiment of Figure 3, for example. The connection diodes 404, 406 may be used to increase isolation with respect to other branches/sections, and reduce the parallel-capacitance of the reversed biased diodes in other switch branches, which lowers an attenuation of signals passing through the other switch branches. The concepts of anti-series and anti-parallel coupling are functional also with respect to the connection diodes 404, 406 on the basis of practical tests.

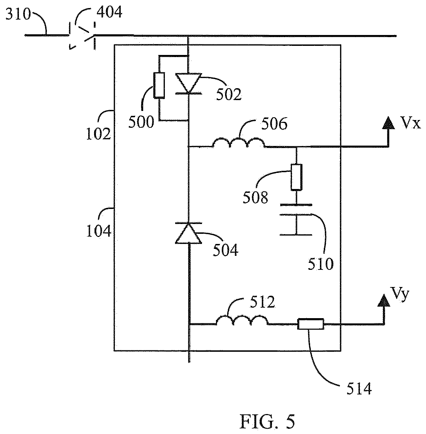

In an embodiment an example of which is illustrated in Figure 5, a diode switch 102, which comprises a series coupling 104 of diodes 502, 504 (series coupling of diodes and diode switch being the same in this example), may comprise a diode resistor 500 parallel to a diode 502 of the series coupling 104, the diode 502 of the series coupling 104 being electrically coupled with the conductor 310 or the connection diode 404, 406. The diode resistor 500 may increase the cancellation of the harmonics in the electronic radio frequency switch arrangement.

The diode resistor 500 may switch the reverse bias to the connection diode 404, 406 in a state where the whole section 400, 402 is off. This reverse bias of the connection diode results in an isolation of the unused section 400, 402 and for harmonics cancellation on the basis of the anti-parallel coupling of diodes of the switch branches, which have diode switches 102 in an electrically non-conductive state. The diode resistor 500 may have a resistance value in a range 100 kΩ to 10 MΩ, for example. In an embodiment, the diode resistor 500 may have a resistance value about 1 MΩ.

In an embodiment, there may be a middle inductor 506 coupled to between the diodes 502, 504 and an input Vx provided by an electric power source in order to improve the cancellation of the harmonics. The input Vx may refer to any of the inputs V2, V4, V6, V8, V10, V12, V14, V16, V18 and V20.

In an embodiment, there may be an outer inductor 512 coupled with an end of the diode switch 102, the end being opposite to an end coupled with the conductor 310 or the connection diode 404, 406, and an input Vy provided by an electric power source in order to improve the cancellation of the harmonics. The input Vy may refer to any of the inputs V3, V5, V7, V9, V11, V13, V15, V17, V19, V21. In an embodiment, there may be a coil resistor 514 in series with the outer inductor 512 in order to improve the cancellation of the harmonics. In an embodiment, the input Vx different from the ground may be coupled to the ground through a ground resistor 508 and/or a ground capacitor 510 in order to improve the cancellation of the harmonics. The ground resistor 508 may have a resistance value in a range 10 Ω to 100 Ω, for example. In an embodiment, the ground resistor 508 may have a resistance value about 33 Ω. If the ground resistor 508 is replace by a resistor parallel to the middle inductor 506, a value of such a resistor is 100 Ω to 50 kΩ.

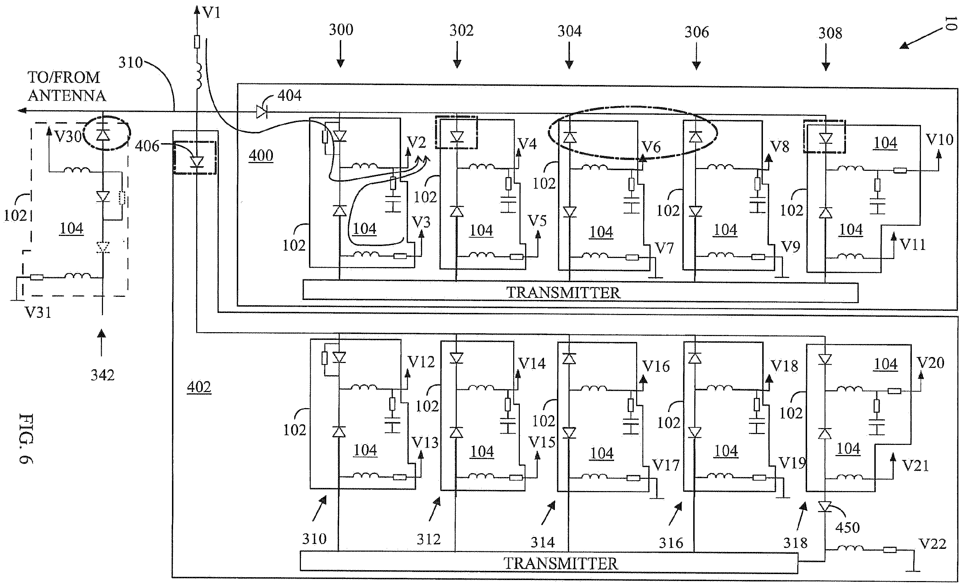

Figure 6 illustrates an example where inputs V1, V2 and V3 cause one of the diode switch 102 having the at least one anti-series coupling 104 of the diodes of the radio frequency power switch branch 300 be in an electrically conductive state. Also the connection diode 404 is in an electrically conductive state. Then an electric DC current (shown with arrow headed line) flows from the input V1 to the input V2. Correspondingly, an electrical DC current (see another of arrow headed lines) flows from the input V3 to the input V2. At the same time, a radio frequency power signal can pass through the radio frequency power switch branch 300 having the anti-series coupling 104, which is in an electrically conducting state, and the connection diode 404 to the antenna 350. Because the other diode switches 102 are biased into an electrically non-conducting state, no radio transmission or reception signal can be pass through them between the transmitter and the antenna 350 and the receiver and the antenna 350. The diodes that have a squared dashed line surrounding them (cathode pointing away from input V1) and the diodes that have an ellipse dashed line surrounding them (cathode pointing toward input V1) cancel harmonics distortion of each other at least partly because the diodes are coupled in an anti-parallel manner. A number of diodes of the anti-parallel coupling having a cathode coupled with the connection diode 404 and a number of diodes of the anti-parallel coupling having an anode coupled with the connection diode 404 is the same for fulfilling the definition of the anti-parallel coupling. The diodes of the anti-series coupling, which is in an electrically conducting state, also cancel harmonics distortion of each other at least partly. Here it can be seen that the diode of the receiver switch branch 342 may be utilized for causing an anti-parallel coupling of diodes. Figure 6 also shows the transmitter that supplies the radio frequency power signal to the diode switches 102 of the radio frequency power transmission switch branches 300 to 318. Although the transmitter is shown using two rectangles, the transmitter may comprise one or more transmitter units which may be in various manners be connected with the diode switches 102 of the radio frequency power transmission switch branches 300 to 318.

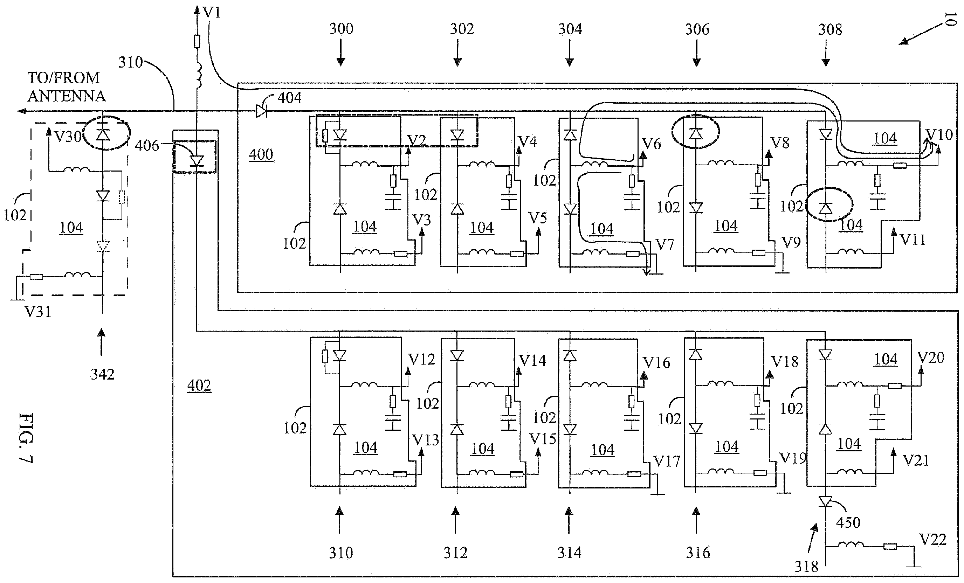

Figure 7 illustrates where inputs V1, V6, V7 and V10 cause one of the diode switches 102 having the at least one anti-series coupling 104 of the diodes of the radio frequency power transmission switch branch 304 be in an electrically conductive state. Also the connection diode 404 is in an electrically conductive state. Then an electric DC current flows from the input V1 to the input V10. Correspondingly, an electrical DC current flows from the input V6 to the input V10. In a similar manner, an electrical DC current flows from the input V6 to the input V7. At the same time, a radio frequency power signal can pass through the radio frequency power switch branch 304 having the anti-series coupling 104, which is in an electrically conducting state, and the connection diode 404 to the antenna 350. Because the other diode switches 102 are biased into an electrically non-conducting state, no other radio transmission or reception signal can be pass through the electronic radio frequency switch arrangement. The diodes that have a squared dashed line surrounding them and the diodes that have an ellipse dashed line surrounding them cancel harmonics distortion of each other at least partly because the diodes are coupled in anti-parallel. The diodes of the anti-series coupling, which is in an electrically conducting state, also cancel harmonics distortion of each other at least partly.

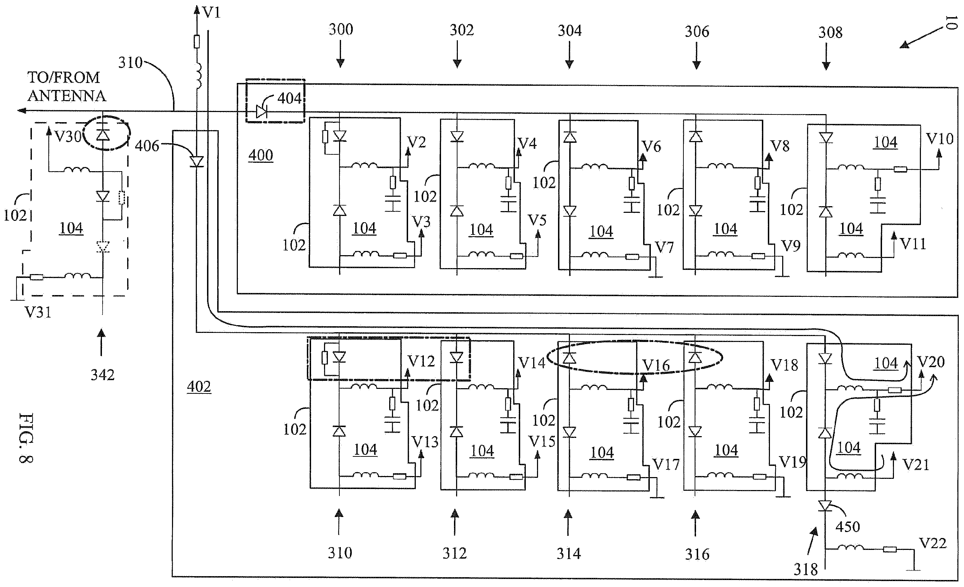

Figure 8 illustrates where inputs V1, V20 and V21 cause one of the diode switches 102 having the at least one anti-series coupling 104 of the diodes of the radio frequency power switch branch 318 be in an electrically conductive state. Also the connection diode 406 is in an electrically conductive state. Then an electric DC current flows from the input V1 to the input V20. Correspondingly, an electrical DC current flows from the input V21 to the input V20. At the same time, a radio frequency power signal can pass through the radio frequency power switch branch 318 having the anti-series coupling 104, which is in an electrically conducting state, and the connection diode 406 to the antenna 350. Because the other diode switches 102 are biased into an electrically non-conducting state, no other radio transmission or reception signal can be pass through the electronic radio frequency switch arrangement. The diodes that have a squared dashed line surrounding them and the diodes that have an ellipse dashed line surrounding them cancel harmonics distortion of each other at least partly because the diodes are coupled in anti-parallel. The diodes of the anti-series coupling, which are in an electrically conducting state, also cancel harmonics distortion of each other at least partly.

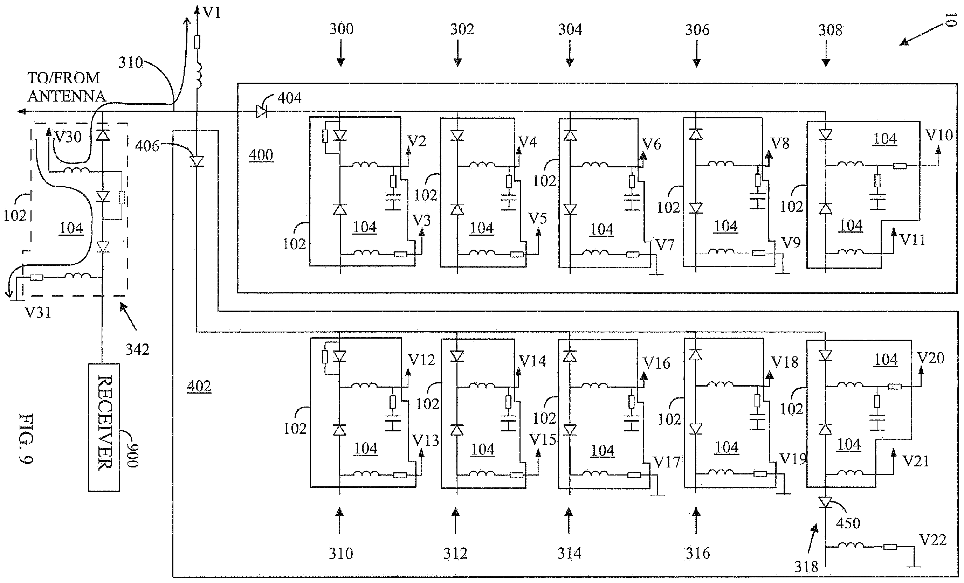

Figure 9 illustrates where inputs V1, V30 and V31 cause one of the diode switches 102 of the radio frequency switch branch 342 be in an electrically conductive state. Then an electric DC current flows from the input V30 to the input V1. Correspondingly, an electrical DC current flows from the input V30 to the input V31. At the same time, a radio frequency power signal can pass through the radio frequency switch branch 342, which is in an electrically conducting state, to the receiver 900. Because the other diode switches 102 are biased into an electrically non-conducting state, no other radio transmission or reception signal can be pass through the electronic radio frequency switch arrangement.

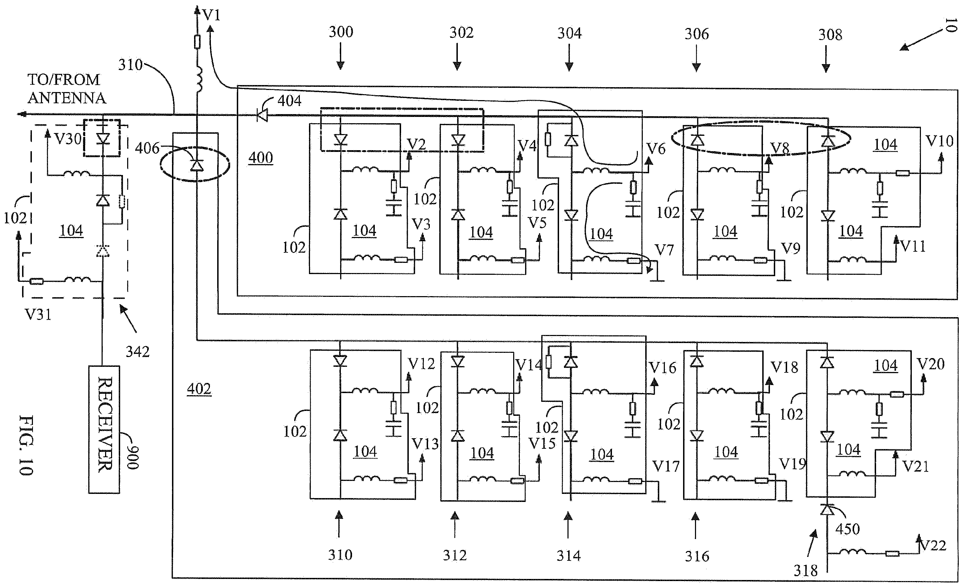

Figure 10 illustrates where inputs V1, V6 and V7 cause one of the diode switches 102 of the radio frequency switch branch 304 be in an electrically conductive state. Then an electric DC current flows from the input V6 to the input V1. Correspondingly, an electrical DC current flows from the input V6 to the input V7. At the same time, a radio frequency power signal can pass through the radio frequency switch branch 304, which is in an electrically conducting state, to the antenna 350. Because the other diode switches 102 are biased into an electrically non-conducting state, no other radio transmission or reception signal can be pass through the electronic radio frequency switch arrangement.

This example shows a dual reverse configuration of the previously presented the 11-branch switch (with the power transmission switch branch 304 in active state). The cathodes of the connection diodes 404 and 406 point towards the antenna and the input V1. The adjustable voltage at the input may go (negative voltages with respect to input V6) and electric currents flow in an opposite direction compared to the previous set-up such as in Figure 9. Note also that the reverse-voltage switching diodes are shifted to different branches which use negative reverse-bias voltage. Also, the diodes in the receiver switch branch 342 are inverted to maintain parallel cancellation balance. The diodes that have a squared dashed line surrounding them and the diodes that have an ellipse dashed line surrounding them cancel harmonics distortion of each other at least partly because the diodes are coupled in anti-parallel. The diodes of the anti-series coupling, which are in an electrically conducting state, also cancel harmonics distortion of each other at least partly. This cancellation is similar to other examples.

In Figure 10, the resistor 500 (see Figure 5) may be used to allow the diode switches 102 in the switch branches 304 and 314 to switch into an electrically non-conductive state when all switch branches of a section 400, 402 are desired to be switched into an electrically non-conducting state. The resistor 508 lowers the level of the harmonic disturbance because it reduces the Q-factor of the coil 506.

In all examples, there is a certain electric current value or a certain electric current range, which causes a harmonic disturbance of the first two diodes and harmonic disturbance of the third diode in anti-series connection in respect to two first diodes to cancel each other. Said two first diodes are the first diode of the diode switch 102 coupled directly to the conductor 310 and the connection diode 404, 406. The said third diode in the anti-series connection is the second diode of the diode switch 102 (FIG. 5). The harmonic disturbance may include the second harmonic disturbance, for example.

Using this kind of electronic radio frequency switch arrangement, a high power and wide frequency band switched filter banks can be designed with smaller diodes requiring less room and less current adjustment. The second harmonic level can be actively adjusted. Some power, frequency band, switching speed and maximum switching cycle-combinations are impossible to implement with current diode technology (or with any other solid-state or related technology) without cancelling switch-produced harmonics by some technique, and this electronic radio frequency switch arrangement provides a solution to this kind of technical problem.

In an embodiment, diodes of high-power, where the high power means about 10 W or over, may be used as RF-switches in the electronic radio frequency switch arrangement without producing too high harmonic levels. The high power may be in range 10 W to 1 kW, for example. The diodes of the high power may comprise PIN-diodes. Typical use is at the output-side switch of a switched filter bank. The anti-series and anti-parallel pairs of PIN diodes can be used to reduce or eliminate the harmonics. The PIN-diodes are arranged such that diodes in an electrically non-conducting state cancel distortion in parallel pairs, and in an electrically conducting state the cancellation is provided by an anti-series pair. Additionally, electric current through one or more of the diodes of the anti-series coupling may be actively adjusted.

Instead of only two diodes in anti-series there may be two or more diodes in series to improve isolation when switched into an electrically non-conducting state. By adjusting the forward current of switch branch biased in an electrically conducting state, an optimal value of bias-current can be found for minimizing the second harmonic distortion caused by the diodes. Also the third harmonic may be limited in this manner. The anti-parallel coupling of diodes affects both the second and higher order harmonics. Combination of the both anti-series and anti-parallel coupling of diodes effectively reduces harmonic level of the electronic radio frequency switch arrangement.

In addition of the anti-series and anti-parallel cancellation techniques, harmonic distortion can be additionally decreased by intentionally decreasing the Q-value of the PIN-diode bias coils. This can be implemented by insertion of serial or parallel resistor with bias-coil. The use of a resistor (typical value is about 33 ohms with about 1.8 µH coil) in series with suitable DC-block capacitor is typical realization of the circuit.

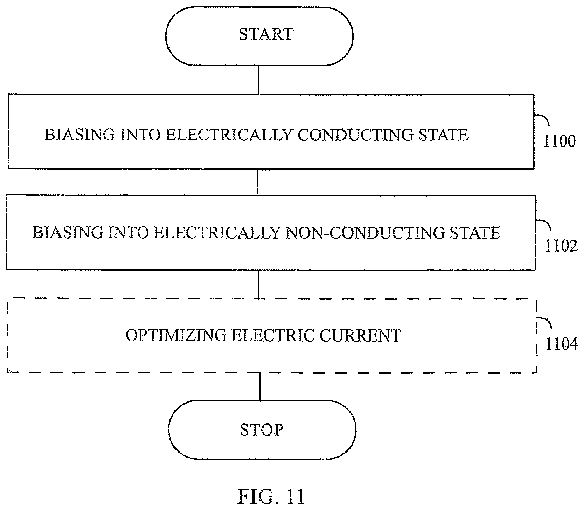

Figure 11 is a flow chart of a method of harmonic control of an electronic radio frequency switch arrangement. The electronic radio frequency switch arrangement comprises switch branches 100, each of which comprises at least one diode switch 102, and the switch branches 100 have an electrical anti-parallel coupling of the diode switches 102 therebetween, a number of the switch branches 100 being 2^{∗}n + 1, where n is a positive integer. In step 1100, one of the diode switches 102, which comprises at least one electrical anti-series coupling 104 of diodes, is biased into an electrically conductive state for harmonic reduction on the basis of the anti-series coupling 104 of diodes of the one of the switch branches 100. In step 1102, the diode switches 102 other than said one of the diode switches 102 are biased into an electrically non-conductive state for harmonic reduction on the basis of the anti-parallel coupling of diodes of the switch branches 100, which have diode switches 102 in an electrically non-conductive state. The method may further comprise step 1104, where an electric DC current from a common input V1 to the diode switches 102, each of which comprise at least one electrical anti-series coupling 104 of diodes, is optimized for the harmonic reduction.

It will be obvious to a person skilled in the art that, as technology advances, the inventive concept can be implemented in various ways. The invention and its embodiments are not limited to the example embodiments described above but may vary within the scope of the claims.

## Claims

1. An electronic radio frequency switch arrangement, **characterized in that** electronic radio frequency switch arrangement comprises switch branches (100), each of which comprises at least one diode switch (102), and the switch branches (100) have an electrical anti-parallel coupling of the diode switches (102) therebetween, a number of the switch branches (100) being 2^{∗}n + 1, where n is a positive integer;
one of the diode switches (102), which comprises at least one electrical anti-series coupling (104) of diodes, is configured to be biased into an electrically conductive state for harmonic cancellation on the basis of the electrical anti-series coupling (104), and the diode switches (102) other than said one of the diode switches (102) are configured to be biased in an electrically non-conductive state for harmonic reduction on the basis of the anti-parallel coupling.

2. The electronic radio frequency switch arrangement of claim 1, **characterized in that** a first (98, 99) of the diode switches (102), which comprises the at least one electrical anti-series coupling (104) of diodes, is configured to be biased into the electrically conductive state at a first moment, and a second (98, 99) of the diode switches (102), which comprises the at least one electrical anti-series coupling (104) of diodes, is configured to be biased into the electrically conductive state at a second moment, where the first and the second moments are different and the first and the second (98, 99) of the diode switches (102) are different.

3. The electronic radio frequency switch arrangement of claim 1, **characterized in that** the switch branches (100), which are electrically coupled in parallel between direct current potentials (V1 to V22), and at least one of the switch branches (100) is a radio frequency power transmission switch branch (300 to 318);
each of the switch branches (100) comprise the diode switch (102), which is configured to receive bias on the basis of the direct current input (V1 to V22, and one terminal of each of the diode switches (102) has an electrical coupling with a conductor (310), which is configured to have an electrical connection with an antenna (150) for electromagnetic radio frequency transmission;
the diode switch (102) of each of the at least one radio frequency power transmission switch branch (300 to 318) comprises one of the at least one anti-series coupling (104) of diodes, and the diodes of only one of the radio frequency power transmission switch branches (300 to 304) are configured to be biased into an electrically conductive state to allow a radio frequency signal to pass therethrough to the conductor (310);
a diode of the diode switch (102) of each of the switch branches (300 to 318, 340, 342) other than said one of the at least one of the radio frequency power transmission switch branch (300 to 318) is configured to be biased onto an electrically non-conductive state to prevent the radio frequency signal to pass therethrough.

4. The electronic radio frequency switch arrangement of claim 3, **characterized in that** a difference between a number of anodes of the diode switches (102), the anodes being coupled with the conductor (310), and cathodes of the diode switches (102), the cathodes being coupled with the conductor (310), is configured to be at most one.

5. The electronic radio frequency switch arrangement of claim 3, **characterized in that** the electronic radio frequency switch arrangement comprises at least one section (400, 402) of the radio frequency power transmission switch branches (300 to 318), which are electrically parallel with each other and between the direct current potentials (V1 to V22).

6. The electronic radio frequency switch arrangement of claim 5, **characterized in that** each of the at least one section (400, 402) comprises a connection diode (404, 406), which the electrical coupling of the diode switches (102) with the conductor (310) is arranged through, and a cathode of the connection diode (404, 406) is coupled with the one terminal of each of the diode switches (102) of the anti-series coupling (104) of the diodes.

7. The electronic radio frequency switch arrangement of claim 5, **characterized in that** each of the at least one section (400, 402) comprises a connection diode (404, 406), which the electrical coupling of the diode switches (102) with the conductor (310) is arranged through, and an anode of the connection diode (404, 406) is coupled with the one terminal of each of the diode switches (102) of the anti-series coupling (104) of the diodes.

8. The electronic radio frequency switch arrangement of claim 1, **characterized in that** the electronic radio frequency switch arrangement comprises a plurality of the diode switches (102) that comprise at least one anti-series coupling (104) of diodes.

9. The electronic radio frequency switch arrangement of claim 1, **characterized in that** the switch branches (100) comprise at least one receiver switch branch (342).

10. The electronic radio frequency switch arrangement of claim 1, **characterized in that** the switch branches (100) comprise at least one radio frequency transmission switch branch (340), which is for limited transmission power.

11. The electronic radio frequency switch arrangement of claim 1, **characterized in that** an electric DC current through the one of the diode switches (102), which comprises at least one electrical anti-series coupling (104) of diodes, has been optimized for the harmonic reduction.

12. A method of harmonic control of an electronic radio frequency switch arrangement, **characterized in that** the electronic radio frequency switch arrangement comprises switch branches (100), each of which comprises at least one diode switch (102), and the switch branches (100) have an electrical anti-parallel coupling of the diode switches (102) therebetween, a number of the switch branches (100) being 2^{∗}n + 1, where n is a positive integer, the method comprising:
biasing (1000) one of the diode switches (102), which comprises at least one electrical anti-series coupling (104) of diodes, into an electrically conductive state for harmonic reduction on the basis of the anti-series coupling (104) of diodes of the one of the switch branches (100); and
biasing (1002) the diode switches (102) other than said one of the diode switches (102) into an electrically non-conductive state for harmonic reduction on the basis of the anti-parallel coupling of diodes of the switch branches (100), which have diode switches (102) in an electrically non-conductive state.

13. The method of claim 12, **characterized by** optimizing an electric DC current from a common input (V1) to the diode switches (102), each of which comprises at least one electrical anti-series coupling (104) of diodes, for the harmonic reduction.
